# EUROPEAN PATENT APPLICATION

(11) **EP 4 676 207 A1**
(43) Date of publication of application: **07.01.2026**
(21) Application number: 23961975.2
(22) Date of filing: 22.12.2023
(51) Int. Cl.: H10K 59/80

(54) **DISPLAY PANEL AND DISPLAY APPARATUS**

(30) Priority: 18.12.2023 CN 202311745639
(71) Applicant: Wuhan China Star Optoelectronics Semiconductor Display Technology Co., Ltd., Wuhan, Hubei 430079 (CN)
(72) Inventor: LIU, Ziming, Wuhan, Hubei 430079 (CN)
(74) Representative: Stöckeler, Ferdinand
(86) International application number: PCT/CN2023/141076
(87) International publication number: WO 2025/129651

(57) **Abstract**

A display panel and a display apparatus are disclosed in the present application. The display panel includes a light-emitting device layer and a light extraction layer. The light-emitting device layer includes light-emitting layers and pixel definition layers. The light extraction layer is located on a light exit side of each of the light-emitting layers and includes a plurality of microlenses and a planarization layer. Each microlens has a first refractive index n₁. The planarization layer completely covers a light exit side of each microlens, and a surface of each microlens facing the light-emitting device layer is exposed from the planarization layer. The planarization layer has a second refractive index n₂, and n₁ < n₂. In a thickness direction of the light-emitting device layer, a projection of each microlens on a plane where the light-emitting device layer is located at least partially overlaps a projection of one of the pixel definition layers on the plane. In the present application, a luminance intensity at the front may be increased by the light extraction layer, and the luminous efficiency of sub-pixels of different colors is adjusted through cooperation between arrayed microlenses and the planarization layer in the light extraction layer. As a result, the luminance consistency of the sub-pixels of different colors is improved at low luminance, thereby alleviating the color cast and improving the display effect of the display panel.

## Description

### TECHNICAL FIELD

The present application relates to but is not limited to display technologies, and in particular to a display panel and a display apparatus.

### BACKGROUND

An organic light-emitting diode (OLED) display panel can emit light by a single-layer light-emitting device or a tandem device. The tandem device can drive multiple light-emitting layers in series and thus can result in significantly increased luminance as compared with the single-layer light-emitting device. However, at low luminance, since a current density in the tandem device is less than half of that in the single-layer light-emitting device, a relatively serious color drift may exist in the tandem device. As a result, a tandem OLED display panel is more prone to obvious color cast and color unevenness problems.

Generally, in order to alleviate color cast and color unevenness, gamma compensation can be performed on the tandem OLED display panel. However, at low luminance, there are differences in actual luminous efficiency of sub-pixels of different colors. For example, usually, a green sub-pixel has relatively high luminous efficiency and a blue sub-pixel has relatively low luminous efficiency. It is usually difficult to guarantee the consistency of luminance gains for sub-pixels of different colors by the gamma compensation. Thus, serious color cast may still exist in the tandem OLED display panel at low luminance.

### SUMMARY

Embodiments of the present application provide a display panel and a display apparatus to ameliorate the technical problem that serious color cast exists in laminated OLED display panels at low brightness.

Technical solutions are disclosed in following embodiments of the present application to solve the technical problem.

A display panel according to one or more embodiments of the present application includes a light-emitting device layer and a light extraction layer.

The light-emitting device layer includes light-emitting layers and pixel definition layers.

The light extraction layer is located on a light exit side of each of the light-emitting layers. The light extraction layer includes a plurality of microlenses and a planarization layer, each of the plurality of microlenses has a first refractive index n₁; the planarization layer completely covers a light exit side of each of the plurality of microlenses, and a surface of each of the plurality of microlenses facing the light-emitting device layer is exposed from the planarization layer, the planarization layer has a second refractive index n₂, and n₁ < n₂.

A thickness direction of the light-emitting device layer is defined as a first direction, and in the first direction, a projection of each of the plurality of microlenses on a plane where the light-emitting device layer is located at least partially overlaps a projection of one of the pixel definition layers on the plane where the light-emitting device layer is located.

Correspondingly, a display apparatus according to one or more embodiments of the present application includes the above display panel in a first aspect.

### BRIEF DESCRIPTION OF THE DRAWINGS

In order to illustrate technical solutions in the embodiments of the present application more clearly, accompanying drawings to be used in the description of the embodiments will be briefly introduced below. Obviously, the accompanying drawings to be described below are merely accompanying drawings of some embodiments of the present application. For those of ordinary skill in the art, other drawings can be obtained based on these drawings without creative efforts.
FIG. 1 is a schematic cross-sectional view of a structure of a display panel according to one or more embodiments of the present application.
FIG. 2 is a schematic partial enlarged diagram of the region A in FIG. 1.
FIG. 3 is a schematic cross-sectional view of another structure of a display panel according to one or more embodiments of the present application.
FIG. 4 is a schematic partial enlarged diagram of the region B in FIG. 3.
FIG. 5 is a schematic top view of a structure of a display panel according to one or more embodiments of the present application.
FIG. 6 is a schematic top view of another structure of a display panel according to one or more embodiments of the present application.
FIG. 7 is a schematic top view of yet another structure of a display panel according to one or more embodiments of the present application.
FIG. 8 is a schematic flowchart of a method of manufacturing a display panel according to one or more embodiments of the present application.

### List of reference signs:

10. light-emitting device layer; 11. light-emitting layer; 111. first light-emitting element; 112. second light-emitting element; 113. third light-emitting element; 114. cross section; 12. pixel definition layer; 121. pixel opening; 122. fourth surface; 13. first electrode layer; 131. third region; 14. second electrode layer; 20. light extraction layer; 21. microlens; 211. first surface; 212. second surface; 213. third surface; 214. first microlens; 215. second microlens; 22. planarization layer; 23. first inorganic layer; 24. second inorganic layer; 30. encapsulation layer; 31. first region; 32. second portion; 40. drive circuit layer; 50. substrate; 60. support pillar.

### DETAILED DESCRIPTION

The technical solutions in the embodiments of the present application will be clearly and completely described below with reference to the accompanying drawings in the embodiments of the present application. Obviously, embodiments described are only some of the embodiments of the present application, rather than all of the embodiments. Based on the embodiments in the present application, all other embodiments obtained by those skilled in the art without creative efforts fall within the scope of protection of the present application.

In the description of the present application, it will be understood that the orientation or positional relationship indicated by terms such as "upper", "lower", "front", "back", "left", "right", "top", "bottom", "inside" and "outside" are based on the orientation or positional relationship shown in the drawings. It is only for the convenience of illustrating the present application and simplifying the description, and does not indicate or imply that the device or element referred to must have a specific orientation, be constructed and operate in a specific orientation, and therefore cannot be understood as limitations on the present application. In addition, the terms "first" and "second" are used for descriptive purposes only and cannot be understood as indicating or implying relative importance or implicitly indicating the quantity of indicated technical features. Therefore, a feature defined with "first" or "second" may explicitly or implicitly include one or more features. In the description of the present application, unless otherwise clearly and specifically limited, "multiple", "a plurality of" and "the plurality of" each mean two or more, and at least one means one, two, or more than two.

A display panel is provided in one or more embodiments of the present application.

In some embodiments, an orthographic projection of the planarization layer on a plane where a cross section of the display panel is located covers at least part of an orthographic projection of each of the plurality of microlenses on the plane where a cross section of the display panel is located.

In some embodiments, each of the plurality of microlenses has a first surface and a second surface that are opposite to each other in the first direction, the second surface facing one of the pixel definition layers.

A lateral direction of the light-emitting device layer is defined as a second direction. In the second direction, the first surface has a first dimension L₁ and the second surface has a second dimension L₂, and L₁ < L₂.

In some embodiments, each of the plurality of microlenses further has a third surface connected between the first surface and the second surface.

An included angle α exists between the third surface and the second surface, each of the light-emitting layers has a maximum light exit angle β, 0° < α < 90° , and 90° ≤ (α + β).

In some embodiments, a direction intersecting the second direction is defined as a third direction; the plurality of microlenses include a plurality of first microlenses arranged at intervals and a plurality of second microlenses arranged at intervals, each of the plurality of first microlenses extends along the third direction, and each of the plurality of second microlenses extends along the second direction.

In some embodiments, the light-emitting layers include first light-emitting elements, second light-emitting elements and third light-emitting elements.

In the first direction, an orthographic projection of a first microlens in the plurality of first microlenses on the plane where the light-emitting device layer is located, is located between an orthographic projection of one of the first light-emitting elements adjacent to the first microlens on the plane where the light-emitting device layer is located and an orthographic projection of one of the second light-emitting elements adjacent to the first microlens on the plane where the light-emitting device layer is located. An orthographic projection of a second microlens in the plurality of second microlenses on the plane where the light-emitting device layer is located, is located between an orthographic projection of one of the second light-emitting elements adjacent to the second microlens on the plane where the light-emitting device layer is located and an orthographic projection of one of the third light-emitting elements adjacent to the second microlens on the plane where the light-emitting device layer is located.

In some embodiments, each of the plurality of microlenses includes an inorganic material, and the inorganic material includes at least one of epoxy resin, acrylic, SiO₂ or SiON.

In some embodiments, the planarization layer includes an organic material and/or an organic-inorganic hybrid material.

In some embodiments, 1.3 ≤ n₁ ≤ 1.6, and 1.5 ≤ n₂ ≤ 1.9.

In some embodiments, the orthographic projection of the planarization layer on the plane where the cross section is located completely covers the orthographic projection of each of the plurality of microlenses on the plane where the cross section is located.

In some embodiments, the display panel further includes an encapsulation layer, and the encapsulation layer is located between the light-emitting device layer and the light extraction layer.

In some embodiments, the orthographic projection of the planarization layer on the plane where the cross section is located covers only part of the orthographic projection of each of the plurality of microlenses on the plane where the cross section is located; and the light extraction layer further includes a portion disposed between the microlenses and the planarization layer to separate the microlenses from the planarization layer.

In some embodiments, the portion disposed between the microlenses and the planarization layer includes a first inorganic layer configured to separate the microlenses from the planarization layer.

In some embodiments, the light extraction layer further includes a second inorganic layer disposed on a side of the planarization layer away from the first inorganic layer to cover the planarization layer.

In some embodiments, the light-emitting device layer further includes a first electrode layer disposed on a side of each of the light-emitting layers facing the light extraction layer to cover the light-emitting layers and contact the pixel definition layers.

In some embodiments, the light-emitting device layer further includes a second electrode layer disposed on a side of each of the light-emitting layers away from the light extraction layer.

In some embodiments, the display panel further includes a drive circuit layer and a substrate.

The drive circuit layer is located on a side of the light-emitting device layer away from the light extraction layer.

The substrate is located on a side of the drive circuit layer away from the light-emitting device layer.

### SUMMARY

### BENEFITS

The display panel according to one or more embodiments of the present application includes a light-emitting device layer and a light extraction layer. The light-emitting device layer includes light-emitting layers arranged at intervals and pixel definition layers. The light extraction layer is located on a light exit side of each of the light-emitting layers. The light extraction layer includes a plurality of microlenses and a planarization layer, each of the plurality of microlenses has a first refractive index n₁; the planarization layer covers a light exit side of each of the plurality of microlenses, and a surface of each of the plurality of microlenses facing the light-emitting device layer is exposed from the planarization layer; the planarization layer has a second refractive index n₂, and the first refractive index n₁ and the second refractive index n₂ satisfy that n₁ < n₂. A thickness direction of the light-emitting device layer is defined as a first direction, in the thickness direction of the light-emitting device layer, a projection of each microlens on a plane where the light-emitting device layer is located at least partially overlaps a projection of one of the pixel definition layers on the plane where the light-emitting device layer is located. A luminance intensity at a front of the display panel may be increased by the light extraction layer. In addition, the luminous efficiency of sub-pixels of different colors is further adjusted through cooperation between arrayed microlenses and the planarization layer in the light extraction layer. As a result, the luminance consistency of the sub-pixels of different colors is improved at low luminance, thereby alleviating the color cast and improving the display effect of the display panel.

Embodiments of the present application will be further illustrated below in combination with the accompanying drawings and specific examples.

In one or more embodiments of the present application, the display panel refers to a tandem OLED display panel.

The tandem OLED display panel can emit light by a tandem device. The tandem device can drive multiple light-emitting layers in series and thus can result in significantly increased luminance as compared with a single-layer light-emitting device. However, at low luminance, since a current density in the tandem device is less than half of that in the single-layer light-emitting device, a relatively serious color drift may exist in the tandem device. As a result, the tandem OLED display panel is more prone to obvious color cast and color unevenness problems. Generally, in order to alleviate the color cast and color unevenness, gamma compensation can be performed on the tandem OLED display panel. However, a conventional gamma compensation method still has many shortcomings. In an aspect, for the gamma compensation, a screen is divided into different blocks for burning, and luminance and chroma of one of the blocks (usually a block at a center of the screen) are selected as target values for compensation, while other blocks may not yet reach set specifications, or the display panel may show obvious color unevenness and stripe markings (mura). In another aspect, there are differences in the actual luminous efficiency of sub-pixels of different colors. For example, usually, a green sub-pixel (abbreviated as G) has relatively high luminous efficiency and a blue sub-pixel (abbreviated as B) has relatively low luminous efficiency, so that the display panel has a greenish display effect at low luminance. That is, at low luminance, it is usually difficult to guarantee the consistency of luminance gains for sub-pixels of different colors by the gamma compensation. As a result, the tandem OLED display panel still has serious color cast.

Moreover, during an evaporation process of light-emitting layers of the tandem device, for adjacent sub-pixels, especially for a red sub-pixel (abbreviated as R) and a green sub-pixel, light-emitting layers are prone to being overlapped and connected, and thus a leakage circuit is formed, which in turn causes the sub-pixels to secretly emit light, resulting in the problem of the adjacent sub-pixels lighting up simultaneously in a monochrome image. In addition, when an operating temperature of the tandem device changes drastically, since a drive current is related to a mobility of a thin film transistor (TFT), the drive current is greatly affected by the operating temperature. The leakage circuit may be regarded as a branch circuit outside an original circuit, when the operating temperature changes drastically, a current in the branch circuit will also be disturbed, and the leakage current is uneven. The leakage current will exacerbate the problem of luminance unevenness and color unevenness on a screen and increase the difficulty of control. Therefore, the existence of the leakage current will aggravate the color cast of the tandem device when temperature changes, and will affect luminance unevenness and color unevenness. As a result, the color drift at low luminance becomes more serious after the gamma compensation.

In light of this, one or more embodiments of the present application provide a display panel. The luminance intensity at the front of the display panel is increased by arranging the light extraction layer on the light exit side of each of the light-emitting layers. In addition, the luminous efficiency of the sub-pixels of different colors is further adjusted through cooperation between the arrayed microlenses and the planarization layer in the light extraction layer. As a result, the luminance consistency of the sub-pixels of different colors is improved at low luminance, thereby alleviating the color cast and improving the display effect of the display panel.

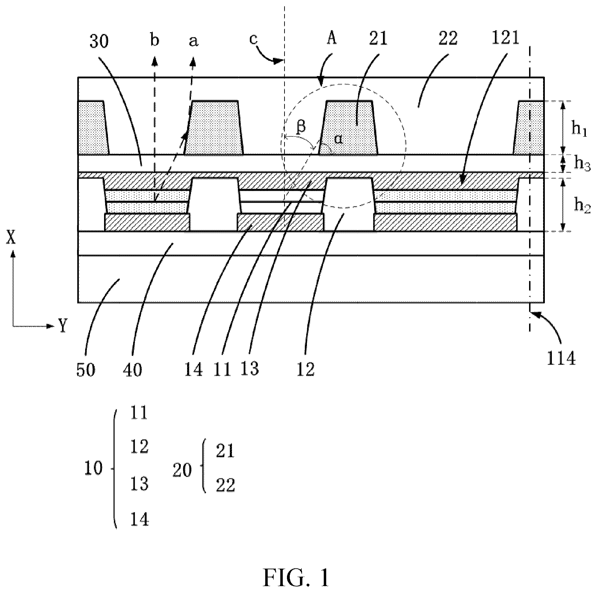

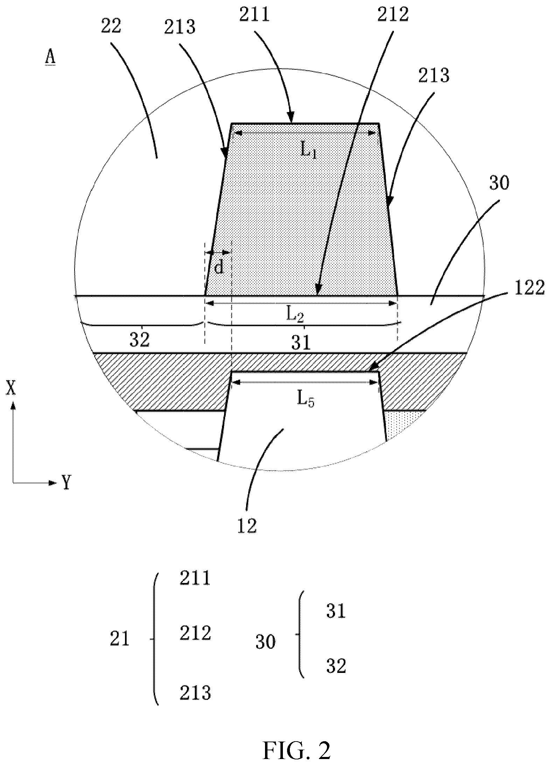

Referring to FIG. 1 and FIG. 2, FIG. 1 is a schematic cross-sectional view of a structure of a display panel according to one or more embodiments of the present application, and FIG. 2 is a schematic partial enlarged diagram of the region A in FIG. 1. The display panel provided in the embodiments of the present application includes a light-emitting device layer 10 and a light extraction layer 20. The light-emitting device layer 10 includes light-emitting layers 11 arranged at intervals and pixel definition layers 12. The light extraction layer 20 is located on a light exit side of each of the light-emitting layers 11. The light extraction layer 20 includes a plurality of microlenses 21 and a planarization layer 22. Each microlens 21 has a first refractive index n₁. The planarization layer 22 completely covers a light exit side of each of the plurality of microlenses 21, and a surface of each microlens 21 facing the light-emitting device layer 10 is exposed from the planarization layer 22. The planarization layer 22 has a second refractive index n₂, and n₁ < n₂. A thickness direction of the light-emitting device layer 10 is defined as a first direction X, and in the first direction X, a projection of each microlens 21 on a plane where the light-emitting device layer 10 is located at least partially overlaps a projection of one of the pixel definition layers 12 on the plane where the light-emitting device layer 10 is located. For example, the first direction X may be perpendicular to the plane where the light-emitting device layer 10 is located.

In some examples, the pixel definition layers 12 define a plurality of pixel openings 121 arranged at intervals, and the light-emitting layers 11 are located in respective pixel openings 121. Each sub-pixel includes a light-emitting layer 11 located in a pixel opening 121. The light-emitting layer 11 is a structure having at least two layers. The light-emitting device layer 10 may further include a first electrode layer 13 and a second electrode layer 14. The first electrode layer 13 is disposed on a side of each light-emitting layer 11 facing the light extraction layer 20 to cover the light-emitting layers 11, and the first electrode layer 13 is in contact with the pixel definition layers 12. The second electrode layer 14 is located on a side of each light-emitting layer 11 away from the light extraction layer 20.

In some examples, the display panel may further include a drive circuit layer 40 and a substrate 50. The drive circuit layer 40 is located on a side of the light-emitting device layer 10 away from the light extraction layer 20, and the substrate 50 is located on a side of the drive circuit layer 40 away from the light-emitting device layer 10.

In some examples, an orthographic projection of the microlens 21 on the plane where the light-emitting device layer 10 is located may be completely located in an orthographic projection of a corresponding pixel definition layer 12 on the plane; or the orthographic projection of the microlens 21 on the plane where the light-emitting device layer 10 is located may also be partially located in the orthographic projection of the corresponding pixel definition layer 12 on the plane.

Specifically, the microlenses 21 and the planarization layer 22 are each made of a light-transmitting material. Since the first refractive index n₁ of the microlens 21 is less than the second refractive index n₂ of the planarization layer 22, in a case where a part of light emitted by a light-emitting layer 11 irradiates an interface formed between a microlens 21 and the planarization layer 22 at a certain angle, the part of light will be fully reflected, and the part of light has a light path as shown in the light path a in FIG. 1; another part of light emitted by the light-emitting layer 11 can be directly transmitted through the planarization layer 22, and the another part of light has a light path as shown in the light path b in FIG. 1; and yet another part of light emitted by the light-emitting layer 11 may exit after entering an inside of the microlens 21, with an refraction angle being be adjusted through the interface formed between the microlens 21 and the planarization layer 22. Therefore, the light extraction layer 20 may play a role in converging light.

For the display panel in the embodiments of the present application, the luminance intensity at the front of the display panel can be improved by the light extraction layer 20; in addition, the luminous efficiency of the sub-pixels of different colors is further adjusted through cooperation between the arrayed microlenses 21 and the planarization layer 22 in the light extraction layer 20. For example, the luminous efficiency of the green sub-pixel may be reduced, or the luminous efficiency of the red sub-pixel may be increased, so that the luminance consistency of the sub-pixels of different colors is improved at low luminance. As a result, the color cast is alleviated and the display effect is significantly improved.

In some embodiments, each microlens 21 may include an inorganic material, and the inorganic material may include at least one of epoxy resin, acrylic, SiO₂ or SiON. For example, each microlens 21 may be made of photoresist. In this way, the microlenses 21 are easy to be patterned, thereby being convenient for manufacturing.

In some embodiments, the planarization layer 22 may include at least one of an organic material or an organic-inorganic hybrid material. For example, the organic material may be a material doped with at least one of ZrO₂ or TiO₂ nanoparticles, and the organic-inorganic hybrid material may be a metalloxane material. In this way, the planarization layer 22 is made of a transparent material with a certain mechanical strength, which may encapsulate the display panel better while taking into account the converging effect of light.

In some embodiments, the microlens 21 has a first light transmittance Ti, and 50% ≤ Ti; the planarization layer 22 has a second light transmittance T₂, and 80% ≤ T₂.

In some embodiments, the first refractive index n₁ satisfies that 1.3 ≤ n₁ ≤ 1.6, and the second refractive index n₂ satisfies that 1.5 ≤ n₂ ≤ 1.9. For example, the first refractive index n₁ may be any one of 1.3, 1.35, 1.4, 1.45, 1.5, 1.55 and 1.6, or may be a value in a range of any two of 1.3, 1.35, 1.4, 1.45, 1.5, 1.55 and 1.6. The second refractive index n₂ may be any one of 1.5, 1.55, 1.6, 1.65, 1.7, 1.75, 1.8, 1.85 and 1.9, or may be a value in a range of any two of 1.5, 1.55, 1.6, 1.65, 1.7, 1.75, 1.8, 1.85 and 1.9.

By arranging the microlenses 21 and planarization layer 22, it has a good encapsulating effect while taking into account the converging effect of light. As a result, a good practicability is achieved.

With continued reference to FIGS. 1 and 2, in some embodiments, an orthographic projection of the planarization layer 22 on a plane where a cross section 114 of the display panel is located covers at least part of an orthographic projection of each microlens 21 on the plane where the cross section 114 is located. In this way, it is beneficial to reduce the thickness of the display panel, thereby better meeting the demand for thinness and lightness of the display panel in practical applications.

In some embodiments, the microlens 21 has a first surface 211 and a second surface 212 that are opposite to each other in the first direction X, the second surface 212 is arranged towards a pixel definition layer 12, and the first surface 211 is arranged away from the pixel definition layer 12. A lateral direction of the light-emitting device layer 10 is defined as the second direction Y, and in the second direction Y, the first surface 211 has a first dimension L₁ and the second surface 212 has a second dimension L₂, and L₁ < L₂. For example, the second direction Y may be parallel to the plane where the light-emitting device layer 10 is located.

In some examples, both the first surface 211 and the second surface 212 may be planar surfaces that are parallel to the plane where the light-emitting device layer 10 is located. The first surface 211 and the second surface 212 may each be in a shape of a rectangle.

In some examples, considering an example in which the orthographic projection of the microlens 21 on the plane where the light-emitting device layer 10 is located is completely located in the orthographic projection of the corresponding pixel definition layer 12 on the plane. The pixel definition layer 12 has a fourth surface 122 facing the second surface 212, and a central axis of the second surface 212 may not coincide with a central axis of the fourth surface 122. The fourth surface 122 has a fifth dimension L₅ in the second direction Y of the light-emitting device layer 10, and the second dimension L₂ of the second surface 212 may be greater than the fifth dimension L₅. In the case where the second dimension L₂ of the second surface 212 is greater than the fifth dimension L₅, on a side of the pixel definition layer along the second direction Y and facing any pixel, the second surface 212 may protrude beyond the fourth surface 122 by an offset d. The offset d satisfies that 0 µm ≤ d ≤ 2 µm. For example, the offset d may be any one of 0 µm, 0.2 µm, 0.4 µm, 0.6 µm, 0.8 µm, 1.0 µm, 1.2 µm, 1.4 µm, 1.6 µm, 1.8 µm and 2.0 µm or a value in a range of any two of 0 µm, 0.2 µm, 0.4 µm, 0.6 µm, 0.8 µm, 1.0 µm, 1.2 µm, 1.4 µm, 1.6 µm, 1.8 µm and 2.0 µm. In this way, the microlens 21 is slightly shifted with respect to a direction in which the pixel emits light, which is more helpful for in-plane wiring arrangement. In addition, it will be understood that the second surface 212 and the fourth surface 122 may also be arranged coaxially. The second dimension L₂ of the second surface 212 may also be less than or equal to the fifth dimension L₅. There is no specific limitation on this.

In some examples, each microlens 21 further has a third surface 213 connected between the first surface 211 and the second surface 212, and the third surface 213 is located in a range of light exiting from a corresponding light-emitting layer 11. An included angle α exists between the third surface 213 and the second surface 212, and the light-emitting layer 11 has a maximum light exit angle β. The included angle α satisfies that 0° < α < 90° , and the included angle α and the maximum light exit angle β satisfy that 90° ≤ (α + β). The maximum light exit angle β is an angle between light emitted with a largest angle and a normal line c perpendicular to the plane where the light-emitting device layer 10 is located.

That is to say, the third surface 213 may be parallel to the light b emitted by the light-emitting layer 11 with the largest angle, or may have a certain angle with the light b emitted by the light-emitting layer 11 with the largest angle. In this way, in a case where the third surface 213 serves as a fully reflecting surface, it may ensure that more light emitted by the light-emitting layer 11 is reflected, thereby greatly improving the luminous efficiency of the corresponding pixel.

In some examples, the third surface 213 is a planar surface. In this way, the microlens 21 has a trapezoidal cross section in an XZ plane formed by the first direction X and the second direction Y, so that light can be better converged to the front of the display panel, and light reflected back to the inside of the display panel is reduced. As a result, a better light converging effect is achieved.

In other examples, the third surface 213 may also be a curved surface. A bending direction of the curved surface may be toward the inside of the microlens 21 or an outside of the microlens 21, which is not specifically limited.

It will be understood that, in the embodiments of the present application, the plurality of microlenses 21 constitute a microlens array and are arranged around respective sub-pixels. For all microlenses 21, parameters such as the first dimension L₁ of the first surface 211, the second dimension L₂ of the second surface 212, the shape of the first surface 211, the shape of the second surface 212, the shape of the third surface 213, and the included angle α between the second surface 212 and an extending direction of the third surface 213 may be different; spacings between microlenses 21 may be the same or different; multiple third surfaces 213, located in ranges of light emitted by different light-emitting layers 11, of a same microlens 21 may have different shapes and dimensions. The specific shape, dimension and arrangement of a microlens 21 should be set and adjusted according to the specific luminous efficiency requirement of a sub-pixel from which the light is extracted, so as to meet the requirements of a corresponding optical path. At the same time, it should also be considered that a film thickness has requirements on multiple factors such as light extraction, encapsulation, and mechanics. In actual production, specific designs may be made based on dimensions of a load substrate and a corresponding array substrate. The larger an area of the fully reflecting interface, the higher a light converging efficiency will be. In this way, the light extraction layer 20 in the embodiments of the present application may be applied to different application scenarios such as medium-sized display screens, small-sized display screens and bent display screens.

With continued reference to FIGS. 1 and 2, in some embodiments, the orthographic projection of the planarization layer 22 on the plane where the cross section 114 is located completely covers the orthographic projection of each of the plurality of microlenses 21 on the plane where the cross section 114 is located. In this case, the plurality of microlenses 21 and the planarization layer 22 are disposed in a same layer, and the plurality of microlenses 21 are located in the planarization layer 22, second surfaces 212 of the microlenses 21 are not covered by the planarization layer 22. The planarization layer 22 covers the plurality of microlenses 21 and is in contact with first surfaces 211 and third surfaces 213 of the microlenses 21.

In some embodiments, the display panel in the embodiments of the present application may further include an encapsulation layer 30, and the encapsulation layer 30 is located between the light-emitting device layer 10 and the light extraction layer 20.

In some examples, a surface of the encapsulation layer 30 away from the light-emitting device layer 10 has first regions 31 arranged at intervals and second regions 32 arranged at intervals. The microlenses 21 are arranged in respective first regions. The second regions 32 are arranged corresponding to the pixel openings 121. The second surface 212 is attached to a first region 31, and the planarization layer 22 is in contact with each second region 32.

For example, a central axis of the second region 32 and a central axis of the corresponding pixel opening 121 may be coaxial.

Specifically, the encapsulation layer 30 may be light-transmissive. Resonant cavities may usually be formed in the encapsulation layer 30. Part of light emitted by the light-emitting layer 11 will continue to be fully reflected in the encapsulation layer 30 until reaching an angle at which the part of light can exit, the part of light passes through an interface between the encapsulation layer 30 and the planarization layer 22, and exits outside the display panel from the planarization layer 22.

In some examples, in the case where both the first surface 211 and the second surface 212 are parallel to the plane where the light-emitting device layer 10 is located, in the first direction X, the microlens 21 has a first height h₁ (µm), the pixel definition layer 12 has a second height h₂ (µm), the encapsulation layer 30 has a third height h₃ (µm), and the heights satisfy that h₁ = δ × (h₂ + h₃), and 0.5 ≤ δ ≤ 1. For example, δ is any one of 0.5, 0.6, 0.7, 0.8, 0.9 and 1.0, or δ is a value in a range of any two of 0.5, 0.6, 0.7, 0.8, 0.9 and 1.0. The second height h₂ is in a range of 5 µm to 20 µm. For example, the second height h₂ is any one of 5 µm, 6 µm, 7 µm, 8 µm, 9 µm, 10 µm, 11 µm, 12 µm, 13 µm, 14 µm, 15 µm, 16 µm, 17 µm, 18 µm, 19 µm and 20 µm, or the second height h₂ is a value in a range of two of 5 µm, 6 µm, 7 µm, 8 µm, 9 µm, 10 µm, 11 µm, 12 µm, 13 µm, 14 µm, 15 µm, 16 µm, 17 µm, 18 µm, 19 µm and 20 µm. The third height h₃ may be 20 µm.

In the above embodiments, the display panel may be encapsulated by the encapsulation layer 30 to isolate the erosion of water vapor, etc. In addition, the luminance intensity at the front of the display panel is increased by the light extraction layer 20, and the shape and distribution of the arrayed microlenses 21 may be adjusted to adjust the luminous efficiency of the sub-pixels of different colors accordingly, thereby improving the luminance consistency of the sub-pixels of different colors at low luminance. As a result, the color cast is alleviated and the display effect is significantly improved. Moreover, the light extraction layer 20 is located on a side of the encapsulation layer 30 away from the light-emitting device layer 10, so that the display panel has a simple structure, which is easily manufactured in processes.

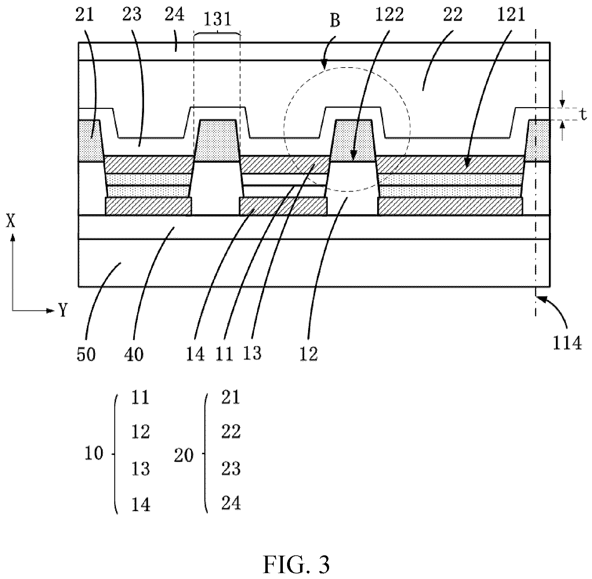

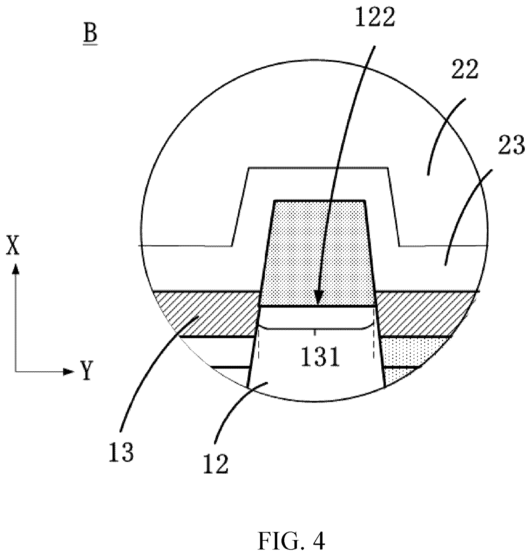

Referring to FIG. 3 and FIG. 4, FIG. 3 is a schematic cross-sectional view of another structure of a display panel according to one or more embodiments of the present application, and FIG. 4 is a schematic partial enlarged diagram of the region B in FIG. 3. In some other embodiments, the orthographic projection of the planarization layer 22 on the plane where the cross section 114 is located covers only part of the orthographic projection of each microlens 21 on the plane where the cross section 114 is located. The light extraction layer 20 further includes a portion located between the microlenses 21 and the planarization layer 22 to separate the microlenses 21 from the planarization layer 22. In this case, the planarization layer 22 is located on a side of each the plurality of microlenses 21 away from the light-emitting device layer 10, and the plurality of microlenses 21 and the planarization layer 22 are arranged in different layers.

In some examples, a surface of the first electrode layer 13 away from the light-emitting layer 11 has third regions 131 arranged at intervals, and a side of the microlens 21 facing the pixel definition layer 12 penetrates through a third region 131 and is in contact with the pixel definition layer 12. That is, the second surface 212 penetrates the third region 131 and is attached to the fourth surface 122 of the pixel definition layer 12. In this way, the microlens 21 may fully break the leakage path of adjacent sub-pixels, thereby alleviating the luminance unevenness and color cast caused by the leakage current, and further improving the display effect of the display panel.

In some embodiments, the portion located between the microlenses 21 and the planarization layer 22 may include a first inorganic layer 23, and the first inorganic layer 23 is located between the microlenses 21 and the planarization layer 22. That is, the first inorganic layer 23 is arranged on the first electrode layer 13 and the microlenses 21 and covers the first electrode layer 13 and the microlenses 21, and the planarization layer 22 is arranged on a side of the first inorganic layer 23 away from the light-emitting device layer 10 and the microlenses 21 to cover the first inorganic layer 23. The first inorganic layer 23 can separate the microlenses 21 from the planarization layer 22.

In some examples, the first inorganic layer 23 is light-transmissive. The first inorganic layer 23 has a thickness t in the first direction X, and the thickness t satisfies that t ≤ 5 µm.

In some examples, the first inorganic layer 23 has a third refractive index n₃, and the third refractive index n₃ satisfies that n₃ = n₁. In this way, the first inorganic layer 23 and the microlenses 21 together constitute a continuous film layer with a low refractive index, and an interface between the first inorganic layer 23 and the planarization layer 22 is configured as a fully reflecting interface, which is beneficial to greatly reducing a thickness of film layers of the display panel, and can also reduce the difficulty of preparation.

In some other examples, the first inorganic layer 23 has a third refractive index n₃, and the third refractive index n₃ satisfies that n₃ = n₂. In this way, the first inorganic layer 23 and the planarization layer 22 together constitute a film layer with a high refractive index, and an interface between the microlenses 21 and the first inorganic layer 23 is configured as a fully reflecting interface. In some other examples, the third refractive index n₃ may also satisfy that n₁ ≤ n₃ ≤ n₂, which may be set as needed.

In some embodiments, the light extraction layer 20 in the embodiments of the present application may further include a second inorganic layer 24. The second inorganic layer 24 is disposed on a side of the planarization layer 22 away from the first inorganic layer 23 to cover the planarization layer 22.

For the above display panel, the luminance intensity at the front of the display panel is increased by the light extraction layer 20, and shapes and distribution of the arrayed microlenses 21 are adjusted to adjust the luminous efficiency of the sub-pixels of different colors accordingly, thereby improving the luminance consistency of the sub-pixels of different colors at low luminance. As a result, the color cast is alleviated and the display effect is significantly improved. In addition, the microlens 21 is attached to the third region 131 of the pixel definition layer 12, so that light-emitting layers 11 of adjacent sub-pixels in the light-emitting device layer 10 cannot overlap with each other and has a certain mechanical strength, thereby greatly improving the effect of the leakage current on color cast. Moreover, the first inorganic layer 23, the planarization layer 22 and the second inorganic layer 24 may constitute an encapsulation structure together, which can also play a role in insulating water vapor and other erosion. At the same time, there is no need to provide an additional encapsulation layer 30, and thus an overall thickness of the display panel is further reduced.

The display panel in the embodiments of the present application is illustrated below from a top view.

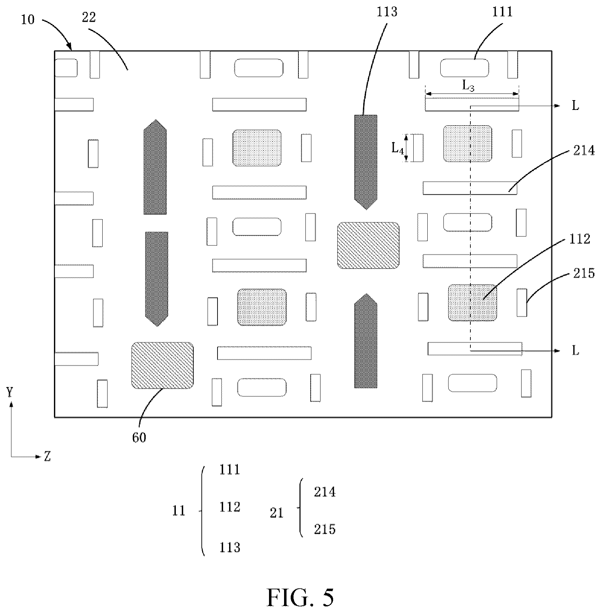

FIG. 5 is a schematic top view of a structure of a display panel according to one or more embodiments of the present application. The cross-sectional structure shown in FIG. 1 and/or the cross-sectional structure shown in FIG. 3 may correspond to a structure in FIG. 5 dissected along the L-L direction. In some embodiments, the display panel may further include support pillars 60 for supporting film layers. A direction intersecting the second direction Y is defined as a third direction Z. The plurality of microlenses 21 may include multiple first microlenses 214 arranged at intervals and multiple second microlenses 215 arranged at intervals. Each first microlens 214 may extend along the third direction Z, and each second microlens 215 may extend along the second direction Y. For example, the second direction Y and the third direction Z are both parallel to the plane where the light-emitting device layer 10 is located, and the second direction Y and the third direction Z are perpendicular to each other.

In some examples, each first microlens 214 has a third dimension L₃ in the third direction Z, each second microlens 215 has a fourth dimension L₄ in the second direction Y, and L₄ < L₃.

In some embodiments, the light-emitting layers 11 arranged at intervals may include: first light-emitting elements 111, second light-emitting elements 112 and third light-emitting elements 113. In the first direction X, an orthographic projection of a first microlens 214 on the plane where the light-emitting device layer 10 is located, is located between an orthographic projection of a first light-emitting element 111 adjacent to the first microlens 214 on the plane where the light-emitting device layer 10 is located and an orthographic projection of a second light-emitting element 112 adjacent to the first microlens 214 on the plane where the light-emitting device layer 10 is located; an orthographic projection of a second microlens 215 on the plane where the light-emitting device layer 10 is located, is located between an orthographic projection of a third light-emitting element 113 adjacent to the second microlens 215 on the plane where the light-emitting device layer 10 is located and an orthographic projection of a second light-emitting element 112 adjacent to the second microlens 215 on the plane where the light-emitting device layer 10 is located; and/or the orthographic projection of the second microlens 215 on the plane where the light-emitting device layer 10 is located, is located between the orthographic projection of the third light-emitting element 113 adjacent to the second microlens 215 on the plane where the light-emitting device layer 10 is located and an orthographic projection of a first light-emitting element 111 adjacent to the second microlens 215 on the plane where the light-emitting device layer 10 is located. For example, the first light-emitting element 111 is a green light-emitting layer, the second light-emitting element 112 is a red light-emitting layer, and the third light-emitting element 113 is a blue light-emitting layer.

It will be understood that, the orthographic projection of the first microlens 214 on the plane where the light-emitting device layer 10 is located may not overlap orthographic projections of two light-emitting layers 11 adjacent to the first microlens 214 on the plane where the light-emitting device layer 10 is located at all, or may partially overlap at least one of the orthographic projections of the two light-emitting layers 11 on the plane where the light-emitting device layer 10 is located. The orthographic projection of the second microlens 215 on the plane where the light-emitting device layer 10 is located may not overlap orthographic projections of two light-emitting layers 11 adjacent to the second microlens 215 on the plane where the light-emitting device layer 10 is located at all, or may partially overlap at least one of the orthographic projections of the two light-emitting layers 11 on the plane where the light-emitting device layer 10 is located.

For example, in the third direction Z, the third dimension L₃ of each first microlens 214 may be greater than a larger one in a dimension of the first light-emitting element 111 and a dimension of the second light-emitting element 112.

By arranging the microlenses 21 in the above manner, a leakage path between the first light-emitting element 111 and the second light-emitting element 112 can be fully broke. As a result, it avoids the problem of adjacent sub-pixels emitting light secretly caused by the leakage current, and also can control of the luminous efficiency of light-emitting layers 111 of the three colors. Based on this, for the third light-emitting element 113 whose luminous efficiency itself is relatively low, there is no need to completely break a corresponding leakage path. Moreover, a part of space may be reserved to facilitate wiring. Therefore, the arrangement is more flexible.

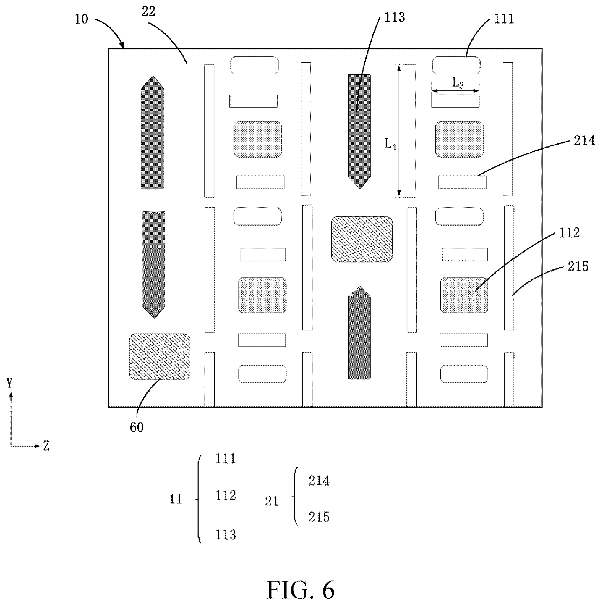

FIG. 6 is a schematic top view of another structure of a display panel according to one or more embodiments of the present application. In some other embodiments, each first microlens 214 has a third dimension L₃ in the third direction Z, each second microlens 215 has a fourth dimension L₄ in the second direction Y, and L₃ < L₄.

In some examples, the light-emitting layers 11 arranged at intervals may include: first light-emitting elements 111, second light-emitting elements 112 and third light-emitting elements 113. in the first direction, an orthographic projection of a first microlens 214 on the plane where the light-emitting device layer 10 is located, is located between an orthographic projection of a first light-emitting element 111 adjacent to the first microlens 214 on the plane where the light-emitting device layer 10 is located and an orthographic projection of a second light-emitting element 112 adjacent to the first microlens 214 on the plane where the light-emitting device layer 10 is located; an orthographic projection of a second microlens 215 on the plane where the light-emitting device layer 10 is located, is located between an orthographic projection of a third light-emitting element 113 adjacent to the second microlens 215 on the plane where the light-emitting device layer 10 is located and an orthographic projection of a second light-emitting element 112 adjacent to the second microlens 215 on the plane where the light-emitting device layer 10 is located; and the orthographic projection of the second microlens 215 on the plane where the light-emitting device layer 10 is located, is located between the orthographic projection of the third light-emitting element 113 adjacent to the second microlens 215 on the plane where the light-emitting device layer 10 is located and an orthographic projection of a first light-emitting element 111 adjacent to the second microlens 215 on the plane where the light-emitting device layer 10 is located. For example, the first light-emitting element 111 is the green light-emitting layer, the second light-emitting element 112 is the red light-emitting layer, and the third light-emitting element 113 is the blue light-emitting layer.

It will be understood that, the orthographic projection of the first microlens 214 on the plane where the light-emitting device layer 10 is located may not overlap orthographic projections of two light-emitting layers 11 adjacent to the first microlens 214 on the plane where the light-emitting device layer 10 is located at all, or may partially overlap at least one of the orthographic projections of the two light-emitting layers 11 on the plane where the light-emitting device layer 10 is located. The orthographic projection of the second microlens 215 on the plane where the light-emitting device layer 10 is located may not overlap orthographic projections of two light-emitting layers 11 adjacent to the second microlens 215 on the plane where the light-emitting device layer 10 is located at all, or may partially overlap at least one of the orthographic projections of the two light-emitting layers 11 on the plane where the light-emitting device layer 10 is located.

By arranging the microlenses 21 in the above manner, a leakage path between the first light-emitting element 111 and the second light-emitting element 112 can be fully broke. As a result, it avoids the problem of adjacent sub-pixels emitting light secretly caused by the leakage current; it can also fully break a leakage path between the first light-emitting element 111 and the third light-emitting element 113, a leakage path between the second light-emitting element 112 and the third light-emitting element 113. In the second direction Y, a length of each of microlenses 21 surrounding the third light-emitting element 113 is increased, which improves the luminous efficiency of the third light-emitting element 113. In addition, the third dimension L₃ of the first microlens 214 in the third direction Z is less than the fourth dimension L₄ of the second microlens 215 in the second direction Y, which is also conducive to reducing the number of microlenses 21 per unit area.

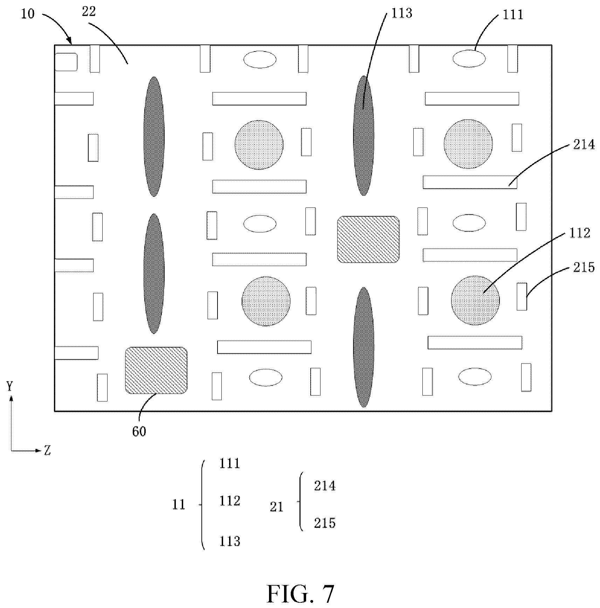

FIG. 7 is a schematic top view of yet another structure of a display panel according to one or more embodiments of the present application. In still other embodiments, the light-emitting layers 11 arranged at intervals may include: first light-emitting elements 111, second light-emitting elements 112 and third light-emitting elements 113 with different shapes and dimensions. In the first direction X, an orthographic projection of a first microlens 214 on the plane where the light-emitting device layer 10 is located, is located between an orthographic projection of a first light-emitting element 111 adjacent to the first microlens 214 on the plane where the light-emitting device layer 10 is located and an orthographic projection of a second light-emitting element 112 adjacent to the first microlens 214 on the plane where the light-emitting device layer 10 is located; an orthographic projection of a second microlens 215 on the plane where the light-emitting device layer 10 is located, is located between an orthographic projection of a third light-emitting element 113 adjacent to the second microlens 215 on the plane where the light-emitting device layer 10 is located and an orthographic projection of a second light-emitting element 112 adjacent to the second microlens 215 on the plane where the light-emitting device layer 10 is located; and/or the orthographic projection of the second microlens 215 on the plane where the light-emitting device layer 10 is located, is located between the orthographic projection of the third light-emitting element 113 adjacent to the second microlens 215 on the plane where the light-emitting device layer 10 is located and an orthographic projection of a first light-emitting element 111 adjacent to the second microlens 215 on the plane where the light-emitting device layer 10 is located. For example, the first light-emitting element 111 is the green light-emitting layer, the second light-emitting element 112 is the red light-emitting layer, and the third light-emitting element 113 is the blue light-emitting layer.

In the above embodiments, the dimensions, spacings and distribution of the microlenses 21 may be adjusted flexibly to meet the light converging requirements and leakage breaking requirements required by different patterned pixel arrangements, which has a high flexibility.

It will be understood that, for the display panel in the embodiments of the present application, the luminous efficiency may be effectively improved, and the problems of color cast and color unevenness at low luminance may be further alleviated by adjusting the shapes and distribution of the arrayed microlenses 21; in addition, the leakage current between adjacent sub-pixels may be reduced, which alleviates the pixels secretly emitting light and improves the encapsulation performance. As a result, the performance of the display panel at low luminance is comprehensively and greatly improved.

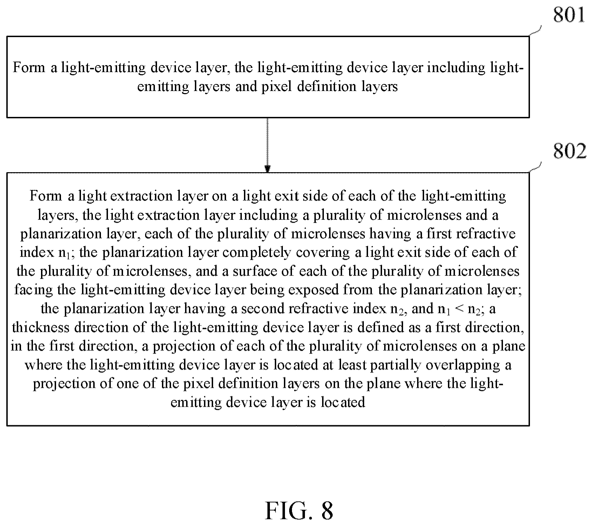

FIG. 8 is a schematic flowchart of a method of manufacturing a display panel according to one or more embodiments of the present application. The method may include the following steps.

In step 801, a light-emitting device layer 10 is formed, and the light-emitting device layer 10 includes light-emitting layers 11 and pixel definition layers 12.

In step 802, a light extraction layer 20 is formed on a light exit side of each of the light-emitting layers 11. The light extraction layer 20 includes a plurality of microlenses 21 and a planarization layer 22, and each microlens 21 has a first refractive index n₁. The planarization layer 22 completely covers a light exit side of each of the plurality of microlenses 21, and a surface of each microlens 21 facing the light-emitting device layer 10 is exposed from the planarization layer 22. The planarization layer 22 has a second refractive index n₂, and n₁ < n₂. A thickness direction of the light-emitting device layer 10 is defined as a first direction X, and in the first direction X, a projection of each microlens 21 on a plane where the light-emitting device layer 10 is located at least partially overlaps a projection of a pixel definition layer 12 on the plane where the light-emitting device layer 10 is located.

In some embodiments, an orthographic projection of the planarization layer 22 on a plane where a cross section 114 of the display panel is located covers at least part of an orthographic projection of each microlens 21 on the plane where the cross section 114 is located.

In some embodiments, forming the light extraction layer 20 on the light exit side of each of the light-emitting layers 11 includes:
forming a microlens layer on the light exit side of each of the light-emitting layers 11.

The microlens layer is etched to form the plurality of microlenses 21, each microlens 21 has a first surface 211 and a second surface 212 that are opposite to each other in the first direction X, the second surface 212 is arranged towards a pixel definition layer 12, and the first surface 211 is arranged away from the pixel definition layer 12. A lateral direction of the light-emitting device layer 10 is defined as a second direction Y, and in the second direction Y, the first surface 211 has a first dimension L₁ and the second surface 212 has a second dimension L₂, and L₁ < L₂.

A planarization layer 22 is formed on the plurality of microlenses 21.

In some embodiments, each microlens 21 further has a third surface 213 connected between the first surface 211 and the second surface 212, and the third surface 213 is located in a range of light exiting from a corresponding light-emitting layer 11. An included angle α exists between the third surface 213 and the second surface 212, and the light-emitting layer 11 has a maximum light exit angle β, the included angle α satisfies that 0° < α < 90° , and the included angle α and the maximum light exit angle β satisfy that 90° ≤ (α + β).

In some embodiments, a direction intersecting the second direction Y is defined as a third direction Z; and etching the microlens layer to form the plurality of microlenses 21 includes:
etching the microlens layer to form a plurality of first microlenses 214 arranged at intervals and a plurality of second microlenses 215 arranged at intervals, each first microlens 214 extending in the third direction Z, and each second microlens 215 extending in the second direction Y.

In some embodiments, the light-emitting layers 11 arranged at intervals include: first light-emitting elements 111, second light-emitting elements 112 and third light-emitting elements 113.

In the first direction X, an orthographic projection of a first microlens 214 on the plane where the light-emitting device layer 10 is located, is located between an orthographic projection of a first light-emitting element 111 adjacent to the first microlens 214 on the plane where the light-emitting device layer 10 is located and an orthographic projection of a second light-emitting element 112 adjacent to the first microlens 214 on the plane where the light-emitting device layer 10 is located; and an orthographic projection of a second microlens 215 on the plane where the light-emitting device layer 10 is located, is located between an orthographic projection of a second light-emitting element 112 adjacent to the second microlens 215 on the plane where the light-emitting device layer 10 is located and an orthographic projection of a third light-emitting element 113 adjacent to the second microlens 215 on the plane where the light-emitting device layer 10 is located.

In some embodiments, each microlens 21 includes an inorganic material, and the inorganic material includes at least one of epoxy resin, acrylic, SiO₂ or SiON.

In some embodiments, the planarization layer 22 includes at least one of an organic material or an organic-inorganic hybrid material.

In some embodiments, the first refractive index n₁ satisfies that 1.3 ≤ n₁ ≤ 1.6, and the second refractive index n₂ satisfies that 1.5 ≤ n₂ ≤ 1.9.

In some embodiments, forming the planarization layer 22 on the plurality of microlenses 21 includes the following step.

A planarization layer 22 is arranged on a side of each of the plurality of microlenses 21 away from the light-emitting device layer 10, and the orthographic projection of the planarization layer 22 on the plane where the cross section 114 is located completely covers the orthographic projection of the microlens 21 on the plane where the cross section 114 is located.

In some embodiments, before forming the plurality of microlenses 21 on the light exit side of each of the light-emitting layers 11, the manufacturing method further includes:
forming an encapsulation layer 30 between the light-emitting device layer 10 and the light extraction layer 20.

In some embodiments, forming the planarization layer 22 on the plurality of microlenses 21 includes:
forming an isolation portion on the side of each of the plurality of microlenses 21 away from the light-emitting device layer 10.

The planarization layer 22 is formed on a side of the isolation portion away from the plurality of microlenses 21, and the orthographic projection of the planarization layer 22 on the plane where the cross section 114 is located only covers part of the orthographic projection of each microlens 21 on the plane where the cross section 114 is located, and the isolation portion separates the microlenses 21 from the planarization layer 22.

In some embodiments, the isolation portion includes a first inorganic layer 23 configured to isolate the microlenses 21 from the planarization layer 22.

In some embodiments, the manufacturing method further includes:
forming a second inorganic layer 24 on a side of the planarization layer 22 away from the first inorganic layer 23.

In some embodiments, forming the light-emitting device layer 10 includes:
forming a first electrode layer 13 on a side of each of the light-emitting layers 11 facing the light extraction layer 20 to cover the light-emitting layer 11 and contact the pixel definition layers 12.

In some embodiments, forming the light-emitting device layer 10 further includes:
forming a second electrode layer 14 on a side of each of the light-emitting layers 11 away from the light extraction layer 20.

In some embodiments, before forming the light-emitting device layer 10, the manufacturing method further includes:
providing a substrate 50; and
forming a drive circuit layer 40 on a side of the substrate 50 facing the light-emitting device layer 10, the drive circuit layer 40 being located on the side of the light-emitting device layer 10 facing away from the light extraction layer 20.

It will be understood that, for the display panel manufactured by the method in the embodiments of the present application, the luminance intensity at the front of the display panel may be increased by fabricating the light extraction layer 20. In addition, the luminous efficiency of sub-pixels of different colors is further adjusted through cooperation between fabricated arrayed microlenses 21 and the planarization layer 22 in the light extraction layer 20. As a result, the luminance consistency of the sub-pixels of different colors is improved at low luminance, thereby alleviating the color cast and significantly improving the display effect of the display panel manufactured by the method.

Accordingly, the display apparatus according to one or more embodiments of the present application includes the display panel described in any of the above embodiments. The display apparatus may be a mobile phone, a computer, a television, a smart wearable device, etc., and the embodiments are not particularly limited thereto.

It will be understood that, for the display apparatus in the embodiments of the present application, the luminance intensity at the front of the display panel may be increased by the light extraction layer 20. In addition, the luminous efficiency of sub-pixels of different colors is further adjusted through cooperation between arrayed microlenses 21 and the planarization layer 22 in the light extraction layer 20. As a result, the luminance consistency of the sub-pixels of different colors is improved at low luminance, thereby alleviating the color cast. Therefore, the display apparatus has a relatively good display effect.

The display panel and the display apparatus provided in the embodiments of the present application have been described above in detail. Specific examples are used herein to illustrate the principles and implementation methods of the present application. The description of the embodiments above is intended only to help understand the technical solutions and core idea thereof in the present application. Those skilled in the art should understand that, they can still modify the technical solutions recorded in the embodiments, or replace some technical features with equivalents. These modifications or replacements do not make the essence of the corresponding technical scheme deviate from the scope of the technical scheme of each embodiment of the present application.

## Claims

1. A display panel, comprising:
a light-emitting device layer comprising light-emitting layers and pixel definition layers; and
a light extraction layer located on a light exit side of each of the light-emitting layers, the light extraction layer comprising a plurality of microlenses and a planarization layer; each of the plurality of microlenses has a first refractive index n₁; the planarization layer completely covers a light exit side of each of the plurality of microlenses, and a surface of each of the plurality of microlenses facing the light-emitting device layer is exposed from the planarization layer, the planarization layer has a second refractive index n₂, and n₁ < n₂;
wherein a thickness direction of the light-emitting device layer is defined as a first direction, in the first direction, a projection of each of the plurality of microlenses on a plane where the light-emitting device layer is located at least partially overlaps a projection of one of the pixel definition layers on the plane where the light-emitting device layer is located.

2. The display panel according to claim 1, wherein an orthographic projection of the planarization layer on a plane where a cross section of the display panel is located covers at least part of an orthographic projection of each of the plurality of microlenses on the plane where a cross section of the display panel is located.

3. The display panel according to claim 1, wherein each of the plurality of microlenses has a first surface and a second surface that are opposite to each other in the first direction, the second surface facing one of the pixel definition layers; and
a lateral direction of the light-emitting device layer is defined as a second direction, in the second direction, the first surface has a first dimension L₁ and the second surface has a second dimension L₂, and L₁ < L₂.

4. The display panel according to claim 3, wherein each of the plurality of microlenses further has a third surface connected between the first surface and the second surface; and
an included angle α exists between the third surface and the second surface, each of the light-emitting layers has a maximum light exit angle β, 0° < α < 90° , and 90° ≤ (α + β).

5. The display panel according to claim 1, wherein a direction intersecting the second direction is defined as a third direction; the plurality of microlenses comprise a plurality of first microlenses arranged at intervals and a plurality of second microlenses arranged at intervals, each of the plurality of first microlenses extends along the third direction, and each of the plurality of second microlenses extends along the second direction.

6. The display panel according to claim 5, wherein the light-emitting layers comprise first light-emitting elements, second light-emitting elements and third light-emitting elements;
in the first direction, an orthographic projection of a first microlens in the plurality of first microlenses on the plane where the light-emitting device layer is located, is located between an orthographic projection of one of the first light-emitting elements adjacent to the first microlens on the plane where the light-emitting device layer is located and an orthographic projection of one of the second light-emitting elements adjacent to the first microlens on the plane where the light-emitting device layer is located; and an orthographic projection of a second microlens in the plurality of second microlenses on the plane where the light-emitting device layer is located, is located between an orthographic projection of one of the second light-emitting elements adjacent to the second microlens on the plane where the light-emitting device layer is located and an orthographic projection of one of the third light-emitting elements adjacent to the second microlens on the plane where the light-emitting device layer is located.

7. The display panel according to claim 1, wherein each of the plurality of microlenses comprises an inorganic material, and the inorganic material comprises at least one of epoxy resin, acrylic, SiO₂ or SiON.

8. The display panel according to claim 1, wherein the planarization layer comprises an organic material and/or an organic-inorganic hybrid material.

9. The display panel according to claim 1, wherein 1.3 ≤ n₁ ≤ 1.6, and 1.5 ≤ n₂ ≤ 1.9.

10. The display panel according to any one of claims 2 to 9, wherein the orthographic projection of the planarization layer on the plane where the cross section is located completely covers the orthographic projection of each of the plurality of microlenses on the plane where the cross section is located.

11. The display panel according to claim 10, further comprising:
an encapsulation layer located between the light-emitting device layer and the light extraction layer.

12. The display panel according to any one of claims 2 to 9, wherein the orthographic projection of the planarization layer on the plane where the cross section is located covers only part of the orthographic projection of each of the plurality of microlenses on the plane where the cross section is located; and
the light extraction layer further includes a portion disposed between the microlenses and the planarization layer to separate the microlenses from the planarization layer.

13. The display panel according to claim 12, wherein the portion disposed between the microlenses and the planarization layer comprises a first inorganic layer configured to separate the microlenses from the planarization layer.

14. The display panel according to claim 13, wherein the light extraction layer further comprises a second inorganic layer disposed on a side of the planarization layer away from the first inorganic layer to cover the planarization layer.

15. The display panel according to claim 1, wherein the light-emitting device layer further comprises a first electrode layer disposed on a side of each of the light-emitting layers facing the light extraction layer to cover the light-emitting layers and contact the pixel definition layers.

16. The display panel according to claim 15, wherein the light-emitting device layer further comprises a second electrode layer disposed on a side of each of the light-emitting layers away from the light extraction layer.

17. The display panel according to claim 1, further comprising:
a drive circuit layer located on a side of the light-emitting device layer away from the light extraction layer; and
a substrate located on a side of the drive circuit layer away from the light-emitting device layer.

18. A display apparatus, comprising the display panel according to any one of claims 1 to 17.
